# EUROPÄISCHE PATENTANMELDUNG

(11) **EP 0 585 205 A2**
(43) Veröffentlichungstag der Anmeldung: **02.03.1994**
(21) Anmeldenummer: 93810580.6
(22) Anmeldetag: 17.08.1993
(51) Int. Cl.: C08L 61/04, C08L 79/08, H01B 3/30

(54) **Furylallylnovolake Bismaleimide härtbare Zusammensetzungen**

(30) Priorität: 26.08.1992 CH 2649/92
(71) Anmelder: CIBA-GEIGY AG, CH-4002 Basel (CH)
(72) Erfinder: Zahir, Sheik Abdul-Cader, Dr., CH-4104 Oberwil (CH); Brunner, Rudolf, Dr., CH-1782 Belfaux (CH)

(57) **Zusammenfassung**

Die Erfindung betrifft neue Zusammensetzungen enthaltend
A) mindestens eine Verbindung der Formel I 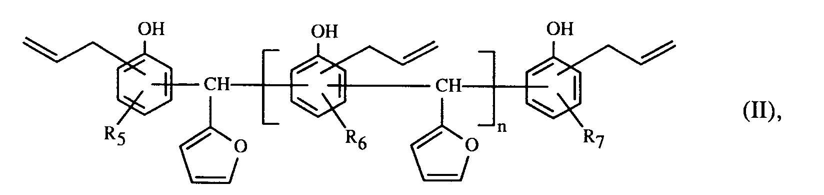 worin R₁, R₂, R₃ und R₄ gleich oder verschieden sind und jeweils Wasserstoff oder Methyl bedeuten und X einen zweiwertigen organischen Rest mit 2 bis 60 C-Atomen darstellt und
B) mindestens eine Verbindungen der Formel II 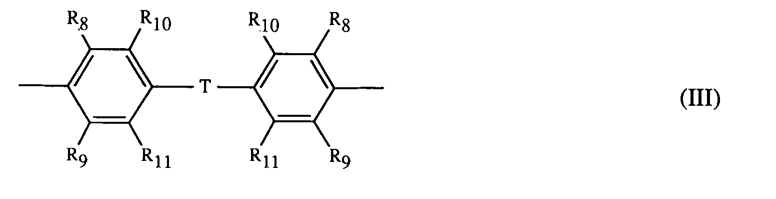 worin R₅, R₆ und R₇ gleich oder verschieden sind und jeweils Wasserstoff, C₁-C₄-Alkyl oder C1-C₄-Alkoxy bedeuten und n eine ganze Zahl von 0 bis 20 darstellt.

Diese Zusammensetzung zeichnen sich durch günstige Verarbeitbarkeitseigenschaften sowie durch sehr hohe Glasumwandlungstemperaturen der daraus gehärteten Produkte aus.

## Beschreibung

Die vorliegende Erfindung betrifft neue härtbare Zusammensetzungen enthaltend Bismaleinimide und Furylallylnovolake, sowie Verfahren zur Herstellung gehärteter Produkte unter Verwendung der erfindungsgemässen Zusammensetzungen.

Allgemein bekannt sind dem Fachmann Zusammensetzungen auf der Basis von Bismaleinimiden und Alkenylphenolen. Beispiele für solche Bismaleinimidsysteme sind in den US-Patenten Nr. 4,100,140 und 4,288,583 beschrieben.

Die bekannten härtbaren Gemische genügen jedoch nicht in jeder Hinsicht den hohen Anforderungen, zum Beispiel bezüglich der Verarbeitbarkeit, da im allgemeinen die Bismaleinimide dazu neigen, auszukristallisieren.

Es wurde nun gefunden, dass Zusammensetzungen basierend auf Bismaleinimiden und Furylallylnovolaken in üblichen organischen Lösungsmitteln gut löslich sind und eine gute Stabilität sowohl bei der Verarbeitungstemperatur (im allgemeinen 80-160 °C) als auch bei Raumtemperatur aufweisen und daher nicht auskristallisieren. Ferner weisen solche Zusammensetzungen bei erhöhter Temperatur längere, also günstigere Verarbeitungszeiten, auf. Weiterhin zeichnen sich die aus den erfindungsgemässen Zusammensetzungen hergestellten gehärteten Produkte durch sehr gute thermische, mechanische und elektrische Eigenschaften sowie sehr hohe Glasumwandlungstemperaturen und hohe Flammfestigkeiten aus.

Gegenstand der vorliegenden Erfindung sind somit Zusammensetzungen enthaltend

### A) mindestens eine Verbindung der Formel I

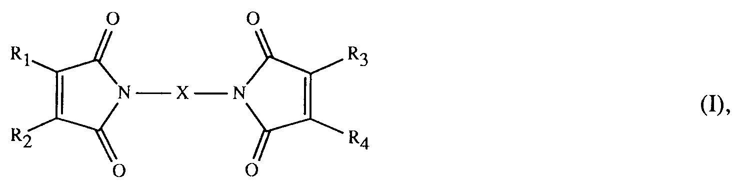

worin R₁, R₂, R₃ und R₄ gleich oder verschieden sind und jeweils Wasserstoff oder Methyl bedeuten und X einen zweiwertigen organischen Rest mit 2 bis 60 C-Atomen darstellt und

### B) mindestens eine Verbindung der Formel II

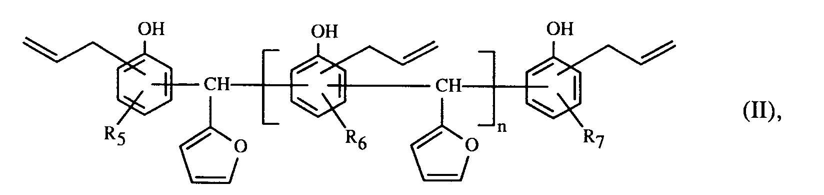

worin R₅, R₆ und R₇ gleich oder verschieden sind und jeweils Wasserstoff, C₁-C₄-Alkyl oder C₁-C₄-Alkoxy bedeuten und n eine ganze Zahl von 0 bis 20 darstellt.

Die Bismaleinimide der Formel I sind bekannte Verbindungen und sind beispielsweise in der US-A 4,100,140 beschrieben. Vorzugsweise handelt es sich um Verbindungen der Formel I, worin X -(CH₂)ₚ- mit p = 2-20, Phenylen, Xylylen, Naphthylen, Cyclopentylen, 1,5,5-Trimethylcyclohexylen-1,3, Cyclohexylen-1,4, 1 ,4-Bis(methylen)cyclohexylen, den Rest des 4,4'-Bicyclohexylmethans oder eine Gruppe der Formel III 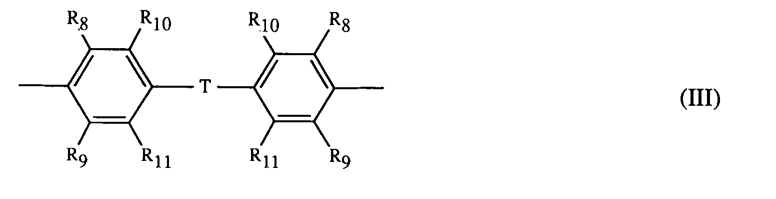
bedeutet, worin R₈ und R₉ gleich oder verschieden sind und jeweils Wasserstoff oder C₁-C₄-Alkyl bedeuten, R₁₀ und R₁₁ unabhängig voneinander je für ein Wasserstoff- oder Halogenatom stehen und T Methylen, 2,2-Propyliden, -CO-, -O-, -S- oder -SO₂- darstellt. Ausserdem bevorzugt sind Verbindungen der Formel I, worin R₁, R₂, R₃ und R₄ Wasserstoff sind.

Besonders bevorzugt sind Verbindungen der Formel I, worin X Hexamethylen, Trimethylhexamethylen (Isomerengemisch), 1,5,5-Trimethylcyclohexylen- 1,3, der Rest des 4,4'-Bicyclohexylmethans oder eine Gruppe der Formel III ist, wobei T Methylen, 2,2-Propyliden, -O- oder -S- ist.

Insbesondere verwendet man Verbindungen der Formel I, worin R₁, R₂, R₃ und R₄ Wasserstoff sind und X eine Gruppe der Formel III darstellt, wobei R₈ und R₉ gleich oder verschieden sind und jeweils Wasserstoff, Methyl oder Ethyl bedeuten, R₁₀ und R₁₁ Wasserstoff sind und T Methylen ist.

Natürlich können auch Mischungen von zwei oder mehr verschiedenen Bismaleinimiden zum Einsatz kommen. Bevorzugt sind Mischungen des N,N'-4,4'-Diphenylmethan-bismaleinimid mit Verbindungen der Formel I, worin R₁, R₂, R₃ und R₄ Wasserstoff sind und X eine Gruppe der Formel III darstellt, wobei R₇ und R₈ gleich oder verschieden sind und jeweils Methyl oder Ethyl bedeuten, R₉ und R₁₀ Wasserstoff sind und T Methylen ist. Das Molverhältnis der unsubstituierten zu den substituierten Bismaleinimide liegt hierbei vorzugsweise von 1 : 0,8 bis 1,2.

Beispiele für Bismaleinimide der Formel I sind: N,N'-Ethylen-bismaleinimid, N,N'-Hexamethylen-bismaleinimid, N,N'-Trimethylhexylen-bismaleinimid, N,N'-m-Pheny-len-bismaleinimid, N,N '-4,4, -Diphenylmethan-bismaleinimid, N,N '-4,4' -Diphenylether-bismaleinimid, N,N'-(1,5,5-Trimethylcyclohexylen-1,3)-bismaleinimid, N,N'-4,4'-Dicyclohexylmethan-bismaleinimid, N,N'-p-Xylylen-bismaleinimid, N,N'-4,4'-Di-(2-ethyl-6-methylphenyl)-methan-bismaleinimid, N,N'-4,4'-Di-(2,6-dimethylphenyl)-methan-bismaleinimid, N,N'-4,4'-Di-(2,6-diethylphenyl)-methan-bismaleinimid, N,N'-4,4'-Di-(2,6-diisopropylphenyl)-methan-bismaleinimid, N,N'-4,4'-Di-(2-ethyl-6-isopropylphenyl)-methan-bismaleinimid und N,N'-4,4'-Di-(3-chlor-2,6-diethylphenyl)-methan-bismaleinimid.

Die Herstellung der Verbindungen gemäss Formel I ist bekannt und erfolgt beispielsweise durch Umsetzung des gegebenenfalls substituierten Maleinsäureanhydrids mit den entsprechenden Diaminen. Übliche Methoden sind beispielsweise in der US-A 3,010,290 oder der GB 1,137,592 beschrieben.

Die Verbindungen der Formel II stellen ebenfalls bekannte Verbindungen dar. Ihre Herstellung ist dem Fachmann allgemein bekannt und erfolgt zum Beispiel durch Umsetzung der entsprechenden Phenole, wie beispielsweise Allylphenol oder Allylkresol, und 2-Furaldehyd (Furfural) in Anwesenheit eines Alkalimetallhydroxids in einem geeigneten Lösungsmittel.

Bevorzugt sind Verbindungen der Formel II, worin R₅, R₆ und R₇ Wasserstoff oder Methyl sind.

Ebenfalls bevorzugt sind Verbindungen der Formel II, worin n eine ganze Zahl von 0 bis 5 darstellt.

Im allgemeinen enthalten die erfindungsgemässen Zusammensetzungen pro Mol der Komponente A 0,01 bis 3 Mol, vorzugsweise 0,3 bis 2,5 Mol, der Komponente B.

Es wird angenommen, dass die Bismaleinimide der Formel I und die Furylallylnovolake der Formel II sehr leicht zu Diels-Alder-Addukten reagieren. Während der Härtung von solchen Addukten werden durch eine Retro-Diels-Alder-Reaktion die Ausgangsverbindungen wieder freigesetzt, welche anschliessend durch eine ENE-Addition weiterreagieren:

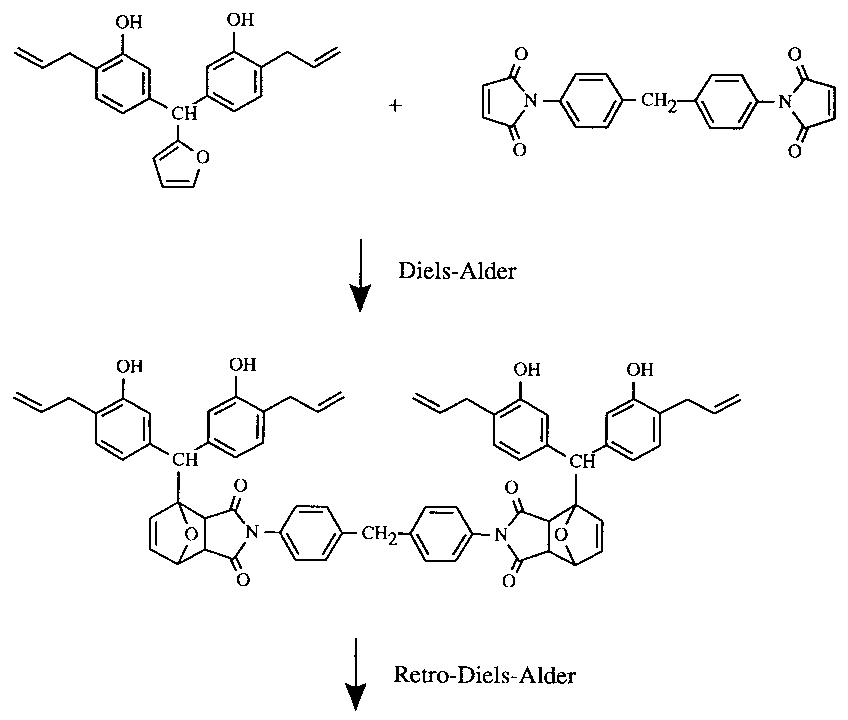

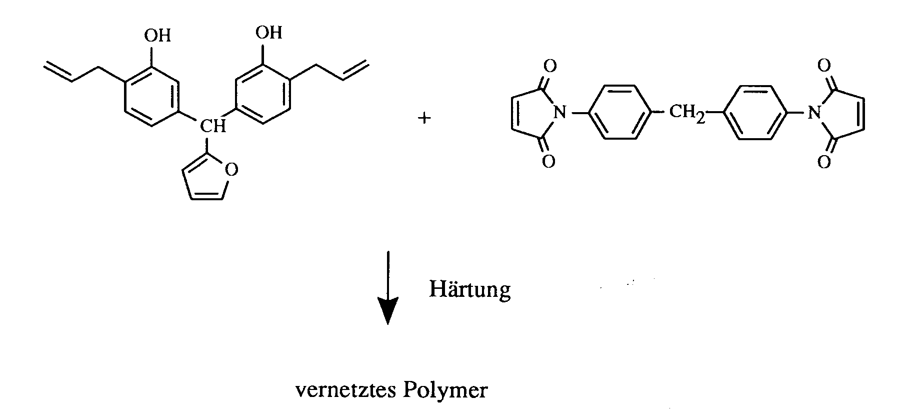

Die erfindungsgemässen Gemische können zusätzlich enthalten

### C) mindestens ein Alkenylphenol oder einen Alkenylphenolether der Formeln IV, V oder VI

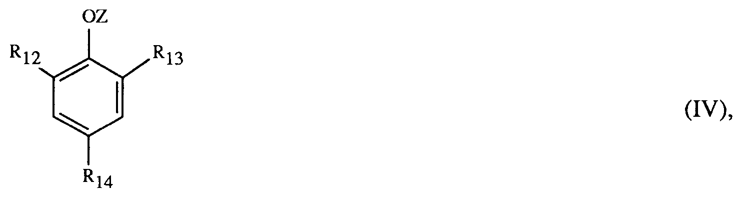

worin R₁₂, R₁₃ und R₁₄ unabhängig voneinander ein Wasserstoffatom, C₁-C₄-Alkyl, C₁-C₄-Alkoxy oder C₃-C₁₀-Alkenyl bedeuten, wobei mindestens einer der Reste R₁₂ bis R₁₄ für eine Alkenylgruppe steht, und Z Wasserstoff, C₁-C₁₀-Alkyl, C₆-C₁₀-Aryl oder C₃-C₁₀-Alkenyl darstellt, 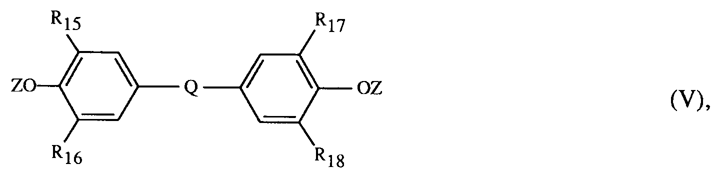
worin Q eine direkte Bindung, Methylen, 2,2-Propyliden, -CO-, -O-, -S-, -SO- oder -SO₂- und R₁₅, R₁₆, R₁₇ und R₁₈ unabhängig voneinander ein Wasserstoffatom, C₁-C₄-Alkyl, C₁-C₄-Alkoxy oder C₃-C₁₀-Alkenyl bedeuten, wobei mindestens einer der Reste R₁₅ bis R₁₈ für eine Alkenylgruppe steht, und Z Wasserstoff, C₁-C₁₀-Alkyl, C₆-C₁₀-Aryl oder C₃-C₁₀-Alkenyl darstellt, 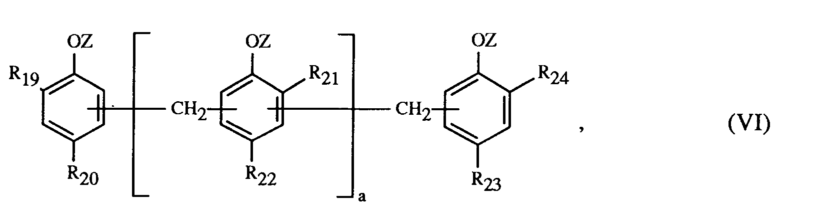
worin R₁₉, R₂₀, R₂₁, R₂₂, R₂₃ und R₂₄ unabhängig voneinander ein Wasserstoffatom, C₁-C₄-Alkyl, C₁-C₄-Alkoxy oder C₃-C₁₀-Alkenyl bedeuten, wobei mindestens einer der Reste R₁₉ bis R₂₄ für eine Alkenylgruppe steht, und a eine Zahl von 0 bis 10 bedeutet, und Z Wasserstoff, C₁-C₁₀-Alkyl, C₆-C₁₀-Aryl oder C₃-C₁₀-Alkenyl darstellt.

Bedeutet in den obigen Definitionen ein Substituent C₁-C₄-Alkyl oder C₁-C₁₀-Alkyl, so kann dieser gradkettig oder verzweigt sein. Beispielsweise handelt es sich bei C₁-C₄-Alkyl um Methyl, Ethyl, n-Propyl, Isopropyl, n-Butyl, sec-Butyl, Isobutyl, oder tert.-Butyl, bei C₁-C₁₀-Alkyl zusätzlich um die verschiedenen Pentyl-, Hexyl-, Heptyl-, Octyl-, Nonyl- oder Decyl-Isomere.

Als C₁-C₄-Alkoxysubstituenten kommen beispielsweise Methoxy, Ethoxy, n-Propoxy oder n-Butoxy in Frage.

Stellt ein Substituent C₃-C₁₀-Alkenyl dar, so kann dieser gradkettig oder verzweigt sein. Beispielsweise handelt es sich um 1-Methylethenyl, 1-Propenyl, 2-Propenyl (Allyl), 2-Methyl-2-propenyl (Methallyl), sowie um die verschiedenen Butenyl-, Pentenyl-, Hexenyl-, Heptenyl-, Octenyl-, Nonenyl- oder Decenyl-Isomere.

Bedeutet ein Substituent C₆-C₁₀-Aryl, so handelt es sich beispielsweise um Phenyl oder Naphthyl.

Als Alkenylgruppe enthalten die Verbindungen der Formeln IV bis VI vorzugsweise ein Allyl, Methallyl oder 1-Propenyl.

Von den Verbindungen der Formeln IV bis VI werden in den erfindungsgemässen Zusammensetzungen bevorzugt Verbindungen der Formel V eingesetzt, worin Q für Methylen, 2,2-Propyliden, -O-, -S-, -CO- oder -SO₂- steht, R₁₅ und R₁₇ je ein Allyl und R₁₆ und R₁₈ je ein Wasserstoffatom bedeuten und Z Wasserstoff darstellt.

Besonders bevorzugt sind Alkenylphenole der Formel V, worin Q für 2,2-Propyliden steht, R₁₅ und R₁₇ je ein Allyl und R₁₆ und R₁₈ je ein Wasserstoffatom bedeuten und Z Wasserstoff darstellt.

Die erfindungsgemässen Zusammensetzungen enthalten im allgemeinen pro Mol der Komponente B 0,1 bis 9 Mol, bevorzugt 0,2 bis 2 Mol, der Komponente C.

Beispiele für alkenylsubstituierte Phenole und Polyole sind beispielsweise o,o'-Diallylbisphenol A, 4,4'-Dihydroxy-3,3'-diallylbiphenyl, Bis-(4-hydroxy-3-allylphenyl)methan, 2,2-Bis-(4-hydroxy-3,5-diallylphenyl)propan, Eugenol (4-Allyl-2-methoxyphenol), 0,0'-Dimethallylbisphenol A, 4,4'-Dihydroxy-3,3'-dimethallylbiphenyl, Bis-(4-hydroxy-3-methallylphenyl)methan, 2,2-Bis-(4-hydroxy-3,5-dimethallylphenyl)propan, 4-Methallyl-2-methoxyphenol, 2,2-Bis-(4-methoxy-3-allylphenyl)propan, 2,2-Bis-(4-methoxy-3-methallylphenyl)propan, 4,4'-Dimethoxy-3,3'-diallylbiphenyl, 4,4'-Dimethoxy-3,3'-dimethallylbiphenyl, Bis-(4-methoxy-3-allylphenyl)methan, Bis-(4-methoxy-3-methallylphenyl)methan, 2,2-Bis-(4-methoxy-3,5-diallylphenyl)propan, 2,2-Bis-(4-methoxy-3,5-dimethallylphenyl)propan, 4-Allylveratrol (4-Allyl-1,2-Dimethoxybenzol) und 4-Methallylveratrol (4-Methallyl-1,2-Dimethoxybenzol).

Die Herstellung der Alkenylphenole ist bekannt und erfolgt beispielsweise durch Umsetzung der entsprechenden Phenole und z.B. Allylchlorid in Anwesenheit eines Alkalimetallhydroxids in einem geeigneten Lösungsmittel, wobei die erhaltenen Produkte anschiessend einer Claisenumlagerung unterworfen werden. Methoden dieser Art sind z.B. in der US-A 4,100,140 und der US-A 4,288,583 beschrieben.

Die erfindungsgemässen Zusammensetzungen können durch blosses Zusammenmischen der Komponenten oder durch Erhitzen der Zusammensetzung bei 75 bis 150°C während etwa 15 bis 90 Minuten hergestellt werden. Um die Umsetzung zu erleichtern, können auch gegebenenfalls Lösungsmittel, besonders flüchtige Lösungsmittel, wie chlorierte Kohlenwasserstoffe, Ester, Etheralkohole oder Tetrahydrofuran, eingesetzt werden. Das Lösungsmittel wird nach der Umsetzung entfernt.

Die Härtung der erfindungsgemässen Zusammensetzungen erfolgt im allgemeinen bei Temperaturen zwischen 100 und 300°C während einer für die Härtung ausreichenden Zeit.

Während der Härtung entsteht ein Netzwerk mit hoher Vernetzungsdichte. Der hier verwendete Ausdruck Härtung bedeutet daher die Umwandlung der niederviskosen Harzmischungen in unlösliche und nichtschmelzbare vernetzte Produkte. Es können so Hochleistungswerkstoffe hergestellt werden, wie z.B. faserverstärkte Verbundwerkstoffe, Strukturklebstoffe, Laminier- oder Elektroharze, die hohen Temperaturen ausgesetzt werden können.

Die erfindungsgemässen Zusammensetzung können in jeder Verarbeitungsphase vor der Härtung mit den üblichen Modifizierungsmitteln vermischt werden, wie z.B. Streckmittel, Formtrennmittel, Füllstoffe und Verstärkungsmittel, Pigmente, Farbstoffe, organische Lösungsmittel, Plastifizierungsmittel, Mittel zur Verbesserung der Trockenklebrigkeit (Klebrigmacher), Gummis oder Beschleuniger. Als Streckmittel, Verstärkungsmittel, Füllstoffe und Pigmente kommen z.B. in Frage: Kohleteer, Bitumen, Glasfasern Borfasern, Kohlefasern, Cellulose, Polyethylenpulver, Polypropylenpulver, Glimmer, Asbest, Quarzpulver, Gips, Antimontrioxid, Bentone, Siliziumdioxidaerogel ("Aerosil"), Lithopon, Barit, Titandioxid, Russ, Graphit, Eisenoxid oder Metallpulver, wie z.B. Aluminium- oder Eisenpulver. Die härtbaren Gemische können auch andere übliche Zusätze, wie z.B. Flammschutzmittel, Thixotropiemittel, Verlaufsmittel, wie Silicone, Celluloseacetatbutyrat, Polyvinylbutyrat, Wachse, Stearate und ähnliches beigegeben werden.

Die härtbaren Zusammensetzungen können auf übliche Art unter Verwendung bekannter Mischaggregate, wie Rührer, Kneter, Walzkörper und ähnliches, herstellt werden.

Die erfindungsgemässen Zusammensetzungen zeichnen sich durch eine sehr gute Verarbeitbarkeit, gute Löslichkeit in üblichen organischen Lösungsmitteln, gute Stabilität in der Schmelze oder in Lösung sowie durch gute thermische und mechanische Eigenschaften der gehärteten Produkte aus. Die erhaltenen Produkte weisen ebenfalls gute elektrische Eigenschaften auf, haben sehr hohe Glasumwandlungstemperaturen und sind nicht brüchig. Die erfindungsgemässen Zusammensetzungen können auch problemlos als Schmelze, z.B. für die Imprägnierung, verwendet werden.

Gegenstand der vorliegenden Erfindung ist daher auch ein Verfahren zur Herstellung gehärteter Produkte unter Verwendung der erfindungsgemässen Zusammensetzungen.

Die beschriebenen erfindungsgemässen Zusammensetzungen können auf verschiedenen Gebieten eingesetzt werden, wie z.B. in Prepregs, Laminaten, z.B. glasverstärkte Laminate für die Elektronik, Verbundwerkstoffen, Leiterplatten, Giesslingen, z.B. als Giessharze für Elektro- oder Elektronikanwendungen, Formkörpern, Klebstoffen und Überzügen. Von besonderem Interesse ist ihre Anwendung für die Herstellung von faserverstärkten Verbundwerkstoffen, welche in der Luftfahrtindustrie sehr wichtig sind. So können die modifizierten Harze zum Präimprägnieren von verschiedenem faserartigem Material verwendet werden, welches als Deckschicht für Honigwabenstrukturen oder als Strukturteile eingesetzt wird. Verfahren zur Herstellung von Prepregs sind dem Fachmann bekannt. Als faserartige Materialien können z.B. Graphit, Glas, Kevlar oder Aramidfasern verwendet werden. Auch Verfahren zur Herstellung von Laminaten sind bekannt. Laminate verschiedener Dicke können z.B. durch Pressformen oder Autoklavformen hergestellt werden. Die erfindungsgemässen Gemische können auch erfolgreich als haftvermittelnde Substanzen eingesetzt werden.

Die folgenden Beispiele erläutern die vorliegende Erfindung weiter.

### I. Synthese der Furylallylnovolake (entsprechend der oben angegebenen Formel II)

### Beispiel A:

In einem 10 l Planschliff-Reaktor mit Kühler, Tropftrichter, Thermometer und N₂-Einleitungsrohr werden unter N₂ 7052,5 g (52,56 mol) o-Allylphenol und 961 g (10 mol) Furfural vorgelegt und dann das Gemisch solange bei Raumtemperatur gerührt, bis eine klare gelbe Lösung entsteht. Anschliessend werden unter Rühren innerhalb von 2 Stunden 423,25 g einer 50 %-igen wässrigen NaOH-Lösung zugegeben. Nach der Erwärmung auf 115 °C wird das Gemisch weitere 6 Stunden gerührt. Danach wird das Gemisch über Nacht auf Raumtemperatur abgekühlt. Das Reaktionsgemisch wird dann mit NaHSO₄ auf einen pH-Wert von 2 eingestellt und filtriert. Die dunkle ölige organische Phase wird anschliessend mit 8,5 l einer 20 %-igen wässrigen NaCl-Lösung gewaschen. Das Gemisch wird nochmals filtriert und die organische Phase im Vakuum destilliert. Es wird ein dunkelbraunes viskoses Harz erhalten (Formel II: R₅ und R₆ bedeuten -H).
Ausbeute: 2477,1 g (71,5 % der Theorie)
Restgehalt an o-Allylphenol: <0,5 %

### II. Herstellungsbeispiele

### Beispiel 1:

Eine Mischung aus 100 g Di-(2-ethyl-6-methylphenyl)-methan-bismaleinimid und 105 g Furylallylnovolak gemäss Beispiel A wird über 75 Minuten bei 140 °C aufgeschmolzen. Es wird eine homogene Mischung mit einer Viskosität η₁₂₀ von 1809 mPa·s erhalten. Die Harzmasse wird in 4 mm dicke Metallformen gegossen und 2 Stunden bei 150 °C, dann 3 Stunden bei 180 °C und 5 Stunden bei 250 °C gehärtet. Nach dem Abkühlen wird die Polymerplatte zu Prüfstäben zerschnitten, an denen folgende Eigenschaften gemessen werden:

| | |
|---|---|
| T_{g} (TMA): | 325°C |
| (Glasumwandlungstemperatur) | |
| Dielektrizitätszahl εᵣ | |
| bei 3 kHz: | 2,99 |
| bei 3 MHz: | 2,92 |
| Zugfestigkeit (DIN 53455) | |
| E-Modul: | 2885 N/mm² |
| σ: | 80,9N/mm² |
| ε: | 3,25% |
| Biegefestigkeit (DIN 53452) | |
| σ: | 107,2 N/mm² |
| ε: | 3,66% |
| Wasseraufnahme: | 2,71% |
| (72 Stunden bei 85 °C und 85 % rel. Luftfeuchtigkeit) | |
| Flammhemmung: | V-0 |
| (UL 94 (4,0 mm)) | |
| Thermische Stabilität | |
| T_{z}(2 %)/T_{z}(5 %)/T_{z}(10 %): | 218 °C/420°C/460°C |
| (Gewichtsverlust von 2 %/5 %/10 % tritt bei der entsprechenden Temperatur ein). | |

### Beispiel 2:

Eine Mischung aus 100 g Di-(2-ethyl-6-methylphenyl)-methan-bismaleinimid und 140 g Furylallylnovolak gemäss Beispiel A wird über 75 Minuten bei 140 °C aufgeschmolzen. Es wird eine homogene Mischung mit einer Viskosität η₁₂₀ von 736 mPa·s erhalten. Die Harzmasse wird in 4 mm dicke Metallformen gegossen und wie in Beispiel 1 gehärtet. Nach dem Abkühlen wird die Polymerplatte zu Prüfstäben zerschnitten, an denen folgende Eigenschaften gemessen werden:
- T_{g} (TMA):: 343 °C
- Dielektrizitätszahl εᵣ:
- bei 3 kHz:: 3,02
- bei 3 MHz:: 2,91.

### Beispiel 3:

Eine Mischung aus 100 g Di-(2-ethyl-6-methylphenyl)-methan-bismaleinimid und 162,4 g Furylallylnovolak gemäss Beispiel A wird über 75 Minuten bei 140 °C aufgeschmolzen. Es wird eine homogene Mischung mit einer Viskosität η₁₂₀ von 1140 mPa·s erhalten. Die Harzmasse wird in 4 mm dicke Metallformen gegossen und wie in Beispiel 1 gehärtet. Nach dem Abkühlen wird die Polymerplatte zu Prüfstäben zerschnitten, an denen folgende Eigenschaften gemessen werden:
- T_{g} (TMA):: 325 °C
- Dielektrizitätszahl εᵣ:
- bei 3 kHz:: 3,15
- bei 3 MHz:: 3,07
- Zugfestigkeit:
- E-Modul:: 3156 N/mm²
- σ:: 67,7 N/mm²
- ε:: 2,54 %
- Biegefestigkeit:
- σ:: 88,3 N/mm²
- ε:: 2,70 %
- Wasseraufnahme:: 1,98 %
- Flammhemmung:: V-0
- Thermische Stabililät:
- T_{z}(2 %)/T_{z}(5 %)/T_{z}(10 %):: 370 °C/430 °C/455 °C.

### Beispiel 4:

Eine Mischung aus 100 g Di-(2-ethyl-6-methylphenyl)-methan-bismaleinimid und 175 g Furylallylnovolak gemäss Beispiel A wird über 75 Minuten bei 140 °C aufgeschmolzen. Es wird eine homogene Mischung mit einer Viskosität η₁₂₀ von 990 mPa·s erhalten. Die Harzmasse wird in 4 mm dicke Metallformen gegossen und wie in Beispiel 1 gehärtet. Nach dem Abkühlen wird die Polymerplatte zu Prüfstäben zerschnitten, an denen folgende Eigenschaften gemessen werden:
- T_{g} (TMA):: 339 °C
- Dielektrizitätszahl εᵣ:
- bei 3 kHz:: 3,06
- bei 3 MHz:: 2,90
- Zugfestigkeit:
- E-Modul:: 3084 N/mm²
- σ:: 71,6 N/mm²
- ε:: 2,67 %
- Biegefestigkeit:
- σ:: 101,0 N/mm²
- ε:: 3,18 %
- Wasseraufnahme:: 1,96 %
- Flammhemmung:: V-0
- Thermische Stabililät:
- T_{z}(2 %)/T_{z}(5 %)/T_{z}(10 %):: 330 °C/420 °C/450 °C.

### Beispiel 5:

Eine Mischung aus 100 g Di-(2-ethyl-6-methylphenyl)-methan-bismaleinimid und 210 g Furylallylnovolak gemäss Beispiel A wird über 75 Minuten bei 140 °C aufgeschmolzen. Es wird eine homogene Mischung mit einer Viskosität η₁₂₀ von 500 mPa·s erhalten. Die Harzmasse wird in 4 mm dicke Metallformen gegossen und wie in Beispiel 1 gehärtet. Nach dem Abkühlen wird die Polymerplatte zu Prüfstäben zerschnitten, an denen folgende Eigenschaften gemessen werden:
- T_{g} (TMA):: 330 °C
- Dielektrizitätszahl εᵣ:
- bei 3 kHz:: 3,13
- bei 3 MHz:: 3,01
- Zugfestigkeit:
- E-Modul:: 2797 N/mm²
- σ:: 66,6 N/mm²
- ε:: 2,43 %
- Biegefestigkeit:
- σ:: 95,8 N/mm²
- ε:: 2,96 %
- Wasseraufnahme:: 1,78 %
- Thermische Stabililät:
- T_{z}(2 %)/T_{z}(5 %)/T_{z}(10 %):: 342 °C/415 °C/450 °C.

### Beispiel 6:

Eine Mischung aus 100 g Di-(2-ethyl-6-methylphenyl)-methan-bismaleinimid und 280 g Furylallylnovolak gemäss Beispiel A wird über 75 Minuten bei 140 °C aufgeschmolzen. Es wird eine homogene Mischung mit einer Viskosität η₁₂₀ von 396 mPa·s erhalten. Die Harzmasse wird in 4 mm dicke Metallformen gegossen und wie in Beispiel 1 gehärtet. Nach dem Abkühlen wird die Polymerplatte zu Prüfstäben zerschnitten, an denen folgende Eigenschaften gemessen werden:
- T_{g} (TMA):: 327 °C
- Dielektrizitätszahl εᵣ:
- bei 3 kHz:: 3,13
- bei 3 MHz:: 3,04
- Zugfestigkeit:
- E-Modul:: 2898 N/mm²
- σ:: 72,7 N/mm²
- ε:: 2,55 %
- Biegefestigkeit:
- σ:: 95,8 N/mm²
- ε:: 2,70 %
- Wasseraufnahme:: 1,17 %
- Flammhemmung:: V-1
- Thermische Stabililät:
- T_{z}(2 %)/T_{z}(5 %)/T_{z}(10 %):: 325 °C/410 °C/425 °C.

## Patentansprüche

1. Zusammensetzungen enthaltend
A) mindestens eine Verbindung der Formel I 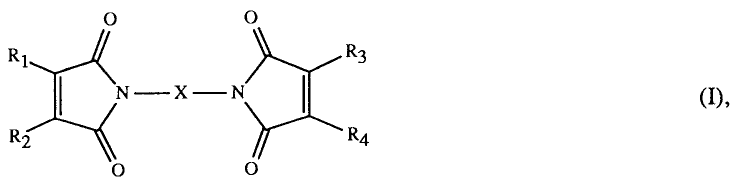 worin R₁, R₂, R₃ und R₄ gleich oder verschieden sind und jeweils Wasserstoff oder Methyl bedeuten und X einen zweiwertigen organischen Rest mit 2 bis 60 C-Atomen darstellt und
B) mindestens eine Verbindung der Formel II 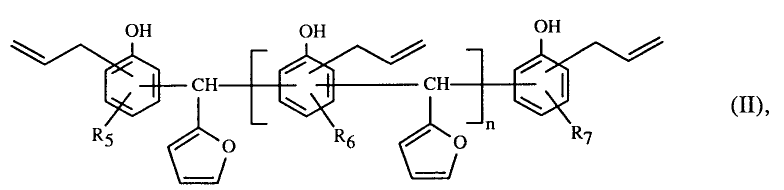 worin R₅, R₆ und R₇ gleich oder verschieden sind und jeweils Wasserstoff, C₁-C₄-Alkyl oder C₁-C₄-Alkoxy bedeuten und n eine ganze Zahl von 0 bis 20 darstellt.

2. Zusammensetzungen gemäss Anspruch 1, worin in der Formel I X -(CH₂)ₚ- mit p = 2-20, Phenylen, Xylylen, Naphthylen, Cyclopentylen, 1,5,5-Trimethylcyclohexylen-1,3, Cyclohexylen- 1,4, 1 ,4-Bis(methylen)cyclohexylen, den Rest des 4,4'-Bicyclohexylmethans oder eine Gruppe der Formel III 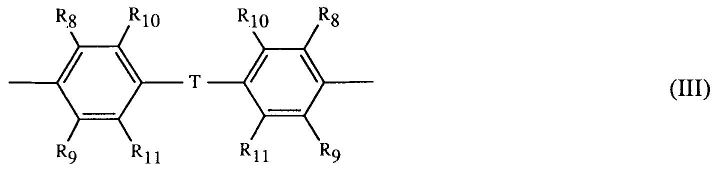 bedeutet, worin R₈ und R₉ gleich oder verschieden sind und jeweils Wasserstoff oder C₁-C₄-Alkyl bedeuten, R₁₀ und R₁₁ unabhängig voneinander je für ein Wasserstoff- oder Halogenatom stehen und T Methylen, 2,2-Propyliden, -CO-, -O-, -S- oder -SO₂- darstellt.

3. Zusammensetzungen gemäss Anspruch 1, worin in der Formel I R₁, R₂, R₃ und R₄ Wasserstoff sind.

4. Zusammensetzungen gemäss Anspruch 1, worin in der Formel I X Hexamethylen, Trimethylhexamethylen (Isomerengemisch), 1,5,5-Trimethylcyclohexylen- 1,3, der Rest des 4,4'-Bicyclohexylmethans oder eine Gruppe der Formel III gemäss Anspruch 2 ist, wobei T Methylen, 2,2-Propyliden, -O- oder -S- ist.

5. Zusammensetzungen gemäss Anspruch 1, worin in der Formel I R₁, R₂, R₃ und R₄ Wasserstoff sind und X eine Gruppe der Formel III gemäss Anspruch 2 darstellt, wobei R₈ und R₉ gleich oder verschieden sind und jeweils Wasserstoff, Methyl oder Ethyl bedeuten, R₁₀ und R₁₁ Wasserstoff sind und T Methylen ist.

6. Zusammensetzungen gemäss Anspruch 1, worin in der Formel II R₅, R₆ und R₇ Wasserstoff oder Methyl sind.

7. Zusammensetzungen gemäss Anspruch 1, worin in der Formel II n eine ganze Zahl von 0 bis 5 darstellt.

8. Zusammensetzungen gemäss Anspruch 1, worin pro Mol der Komponente A 0,01 bis 3 Mol der Komponente B enthalten ist.

9. Zusammensetzungen gemäss Anspruch 1 enthaltend zusätzlich
C) mindestens ein Alkenylphenol oder einen Alkenylphenolether der Formeln IV, V oder VI 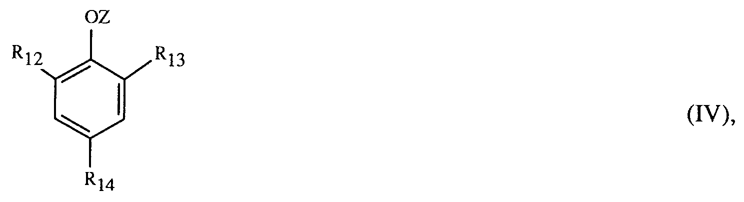 worin R₁₂, R₁₃ und R₁₄ unabhängig voneinander ein Wasserstoffatom, C₁-C₄-Alkyl, C₁-C₄-Alkoxy oder C₃-C₁₀-Alkenyl bedeuten, wobei mindestens einer der Reste R₁₂ bis R₁₄ für eine Alkenylgruppe steht, und Z Wasserstoff, C₁-C₁₀-Alkyl, C₆-C₁₀-Aryl oder C₃-C₁₀-Alkenyl darstellt, 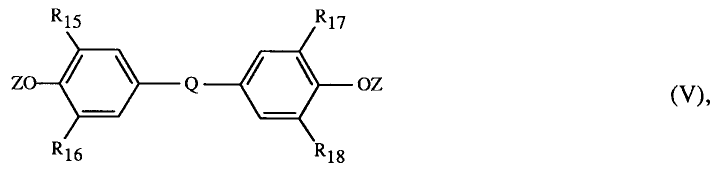 worin Q eine direkte Bindung, Methylen, 2,2-Propyliden, -CO-, -O-, -S-, -SO- oder -SO₂- und R₁₅, R₁₆, R₁₇ und R₁₈ unabhängig voneinander ein Wasserstoffatom, C₁-C₄-Alkyl, C₁-C₄-Alkoxy oder C₃-C₁₀-Alkenyl bedeuten, wobei mindestens einer der Reste R₁₅ bis R₁₈ für eine Alkenylgruppe steht, und Z Wasserstoff, C₁-C₁₀-Alkyl, C₆-C₁₀-Aryl oder C₃-C₁₀-Alkenyl darstellt, 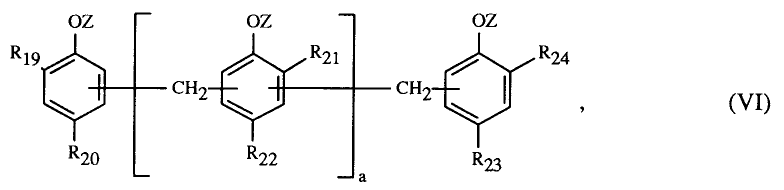
worin R₁₉, R₂₀, R₂₁, R₂₂, R₂₃ und R₂₄ unabhängig voneinander ein Wasserstoffatom, C₁-C₄-Alkyl, C₁-C₄-Alkoxy oder C₃-C₁₀-Alkenyl bedeuten, wobei mindestens einer der Reste R₁₉ bis R₂₄ für eine Alkenylgruppe steht, und a eine Zahl von 0 bis 10 bedeutet, und Z Wasserstoff, C₁-C₁₀-Alkyl, C₆-C₁₀-Aryl oder C₃-C₁₀-Alkenyl darstellt.

10. Zusammensetzungen gemäss Anspruch 9, worin in den Formeln IV bis VI die Alkenylgruppe ein Allyl, Methallyl oder 1-Propenyl ist.

11. Zusammensetzungen gemäss Anspruch 9, enthaltend ein Alkenylphenol der Formel V, worin Q für Methylen, 2,2-Propyliden, -O-, -S-, -CO- oder -SO₂- steht, R₁₅ und R₁₇ je ein Allyl und R₁₆ und R₁₈ je ein Wasserstoffatom bedeuten und Z Wasserstoff darstellt.

12. Zusammensetzungen gemäss Anspruch 9, enthaltend Alkenylphenole der Formel V, worin Q für 2,2-Propyliden steht, R₁₅ und R₁₇ je ein Allyl und R₁₆ und R₁₈ je ein Wasserstoffatom bedeuten und Z Wasserstoff darstellt.

13. Zusammensetzungen gemäss Anspruch 9, worin pro Mol der Komponente B 0,1 bis 9 Mol der Komponente C enthalten sind.

14. Verfahren zur Herstellung gehärteter Produkte unter Verwendung der Zusammensetzungen gemäss Anspruch 1 oder Anspruch 9.

15. Verwendung der Zusammensetzung gemäss Anspruch 1 oder Anspruch 9 zur Herstellung von glasverstärkten Laminaten für die Elektronik.

16. Verwendung der Zusammensetzung gemäss Anspruch 1 oder Anspruch 9 zur Herstellung von faserverstärkten Verbundwerkstoffen in der Luftfahrtindustrie.
